# EUROPEAN PATENT APPLICATION

(11) **EP 1 806 788 A2**
(43) Date of publication of application: **11.07.2007**
(21) Application number: 06026218.5
(22) Date of filing: 18.12.2006
(51) Int. Cl.: H01L 29/788, H01L 21/336, H01L 27/115

(54) **Semiconductor memory device and method for producing the same**

(30) Priority: 10.01.2006 JP 2006002428
(71) Applicant: Renesas Technology Corp., Tokyo 100-6334 (JP)
(72) Inventor: Ishigaki, Takashi, c/o Hitachi Ltd., Tokyo 100-8220 (JP); Osabe, Taro, c/o Hitachi Ltd., Tokyo 100-8220 (JP); Kobayashi, Takashi, c/o Hitachi Ltd., Tokyo 100-8220 (JP); Imai, Yutaka, c/o Renesas Tech. Corp., Tokyo 100-6334 (JP); Shimizu, Masahiro, c/o Renesas Tech. Corp., Tokyo 100-6334 (JP)
(74) Representative: Strehl Schübel-Hopf & Partner

(57) **Abstract**

A semiconductor device comprises a floating gate which is formed on a semiconductor substrate of a first conductive type interposing a first gate insulation layer therebetween, a second charge retaining area which is formed on the semiconductor substrate interposing a second insulation layer, a control gate which is formed on the floating gate interposing a second gate insulation layer therebetween, a second gate electrode which extends in the first direction and which is formed on the second charge retaining region interposing the second gate insulation layer therebetween, and a semiconductor layer which extends in a second direction and which is formed on the semiconductor substrate so as to intersect the first and the second gate electrode are provided; wherein an n-type conductive region of a second conductive type is formed on the semiconductor layer. Consequently, it achieves high-integration of a semiconductor device.

## Description

### TECHNICAL FIELD OF THE INVENTION

The present invention relates to a semiconductor device, and a method for producing the same. In particular, the invention relates to a technology effectively applied to higher integration and higher performance of an electrically rewritable non-volatile semiconductor memory device.

### BACKGROUND OF THE INVENTION

So-called flash memory is known among electrically rewritable non-volatile semiconductor memory devices, as a memory in which information can be erased in block. Flash memory is excellent in portability and anti-shock properties, and also allows electrical erase of information in block. Consequently, a demand on flash memory is rapidly expanding in recent years as a memory device for use in small-size portable information equipments such as portable personal computers, digital still cameras and the like. For the expansion of the market thereof, a reduction of bit cost by means of the shrinkage of an area of memory cells becomes an important factor.

Japanese Patent Application Laid-Open Publication No. 02-110981 (Patent Document 1) describes a flash memory having a virtual ground type memory cell which uses a three-layer polycrystalline silicon film gate. The memory cell described in this document comprises a semiconductor region which is formed on a well in a semiconductor substrate, and three gate electrodes. The three gate electrodes refer to a floating gate which is formed on a well, a control gate which is formed extending over the well and the floating gate, and an erase gate which is formed between the control gate and the floating gate which are located adjacent to each other. The three gate electrodes comprise a polycrystalline silicon film, and are separated respectively with an insulation layer. The floating gate and the well are separated with an insulation layer. The control gate is connected in a row direction to constitute a word line. Source and drain diffusion layers are formed in a column direction to constitute a local data line with the result that a virtual ground type memory cell is formed which shares the diffusion layer with the adjacent memory cells to attempt to alleviate a pitch in a column direction. The erase gate is formed in parallel with the channel and is arranged in parallel with and between the word lines (control gates).

At the time of writing to (programming) the memory cell, a positive potential is applied respectively in an independent manner to the word line and the drain to set the well, the source, and the erase gate to a voltage of 0V. As a consequence, hot electrons are generated at a channel portion located in the vicinity of the drain with the result that electrons are injected to the floating gate, and a threshold voltage of the memory cell is increased. At the time of erase operation, a positive potential is applied to the erase gate to set the word line, the source and the drain, and the well to a voltage of 0V. As a consequence, electrons are released from the floating gate to the erase gate with the result that the threshold voltage is decreased.

Japanese Patent Application Laid-Open Publication No. 2001-156275 (Patent Document 2) discloses a non-volatile semiconductor memory device having a memory cell using a three-layer polycrystalline silicon film gate. With respect to the memory cell in this document, the third gate electrode except for the floating gate and the control gate are allowed to extend in a direction of the data line, and an inversion layer which is formed in the substrate at the time of turning on the channel located below the third gate electrode is used as a local data line. As a consequence, the diffusion layer in the memory array can be deleted with the result that the pitch of the data line can be alleviated.

Incidentally, in the virtual ground type memory cell structure, even though the same diffusion layer interconnect (wiring) or the inversion layer interconnect is used, there is a case where it functions as a source line as well as a case where it functions a data line. Consequently, in the present specification, the diffusion layer interconnect or the inversion layer interconnect which intersects the word line is described as a local data line or a data line. However, depending on the selected memory cell, these interconnects may function as a source line in some cases.

Furthermore, in the investigation which was independently carried out by the applicant of the present application after the present invention, Japanese Patent Application Laid-Open Publication No. 2000-294660 (Patent Document 3) was found which relates to the invention of the present application. In the Patent Document 3, there is disclosed a structure in which a source and drain impurity region is formed which is laminated sandwiching a channel formation region on the surface portion of the semiconductor, and a gate insulating layer including a charge accumulation means (floating gate) inside and a gate electrode (floating gate) are laminated on the channel formation region.

### SUMMARY OF THE INVENTION

There are required three problems to be solved in a flash memory which has so-called contact-less type memory array configuration in which a source and drain of a memory cell transistor is used as a local data line, namely, the data line is formed under the word line so that there is no contact holes for data line in each memory cell, as problems arise in scaling. The three problems are described in detail as follows.

As described above, in the cell method (Patent Document 1) which uses diffusion layer which is formed on the silicon substrate surface as a local data line, a cross-section area of the diffusion layer is decreased and the electric resistance of the data line is heightened along with a decrease in the line width of the data line according to scaling. There arises a problem in that when the electric resistance of the data line is heightened, the reading performance is particularly decreased owing to the fall in the potential and a delay in the response of the electric signal. Consequently, it is required to decrease the electric resistance of the conductive region constituting the data line and to secure the reading speed (1).

Furthermore, at the time of writing the information, as described hereinafter, the junction voltage (junction breakdown voltage) between the diffusion layer constituting the local data line and the well is required to be set to 4V or more. For example, in a cell in which writing is conducted by means of hot electron charging, a voltage of about 12V is applied to the control gate, and a voltage of about 4V or more is applied to the drain with the result that a potential difference between the drain and the source of 0V is used to generate a channel hot electron. At this time, the junction voltage between the drain and the well must exceed the drain voltage. Furthermore, in the local data line to which this drain voltage is applied, a junction leakage current between the diffusion layer and the well becomes a factor of decreasing the writing performance such as a fall in the drain voltage. Consequently, an unnecessary leakage current between the conductive region constituting the local data line and the well is required to be decreased. In other words, it is required to secure the junction voltage between the conductive region and the well (2).

On the other hand, in the flash memory, a potential difference of about 1V between the source and the drain is generated at the time of reading information to prevent the generation of a punch-through with respect to a voltage between the source and the drain for the judgment of the threshold voltage of the memory cell. In the same manner, at the writing as well, the generation of the punch-through must be prevented with respect to the voltage of about 4V or more between the source and the drain of the writing cell. This holds true of the write-inhibit (program-inhibit) cell to which the drain voltage and the source voltage that are the same as the writing cell are applied. It is required to suppress the unnecessary leakage current. As another example, a virtual ground type cell is cited. In this type of the cell, the device isolation is conducted in a select gate, a control gate or the like. As described above, at the time of writing, a voltage of about 4V is applied to the diffusion layer. At a portion where the device isolation is conducted as well, it is required to prevent punch-through. Consequently, it is required to secure a channel length between the source and the drain of the memory cell and to suppress punch-through resulting from the short channel effect (3).

In order to lower the resistance of the data line of the problem (1), either the impurity concentration of the diffusion layer is increased or the depth of the diffusion layer is further deepened to increase the cross-section area. However, when the impurity concentration is increased, the deterioration of the junction voltage of the problem (2) is posed; on the other hand, when the depth of the diffusion layer is deepened, the punch-through endurance between the source and the drain of the problem (3) becomes a problem at the deep portion of the substrate.

Furthermore, generally, a measure is taken by increasing the channel concentration with respect to the deterioration of the punch-through endurance between the source and the drain resulting from the short channel. Consequently, a difference in the impurity concentration between the diffusion layer and the channel becomes large with the result that the junction voltage of the problem (2) becomes a more serious problem with a progress of scaling.

On the other hand, in the cell method (Patent Document 2) using the inversion layer as the data line, it is not required to form a diffusion layer with the result that it becomes possible to decrease the junction leakage current of the problem (2) and to improve the punch-through endurance of the problem (3) as compared with the case in which the diffusion layer is used. However, in the generation of the 50nm design rule, there arises a problem in that the resistance of the data line using the inversion layer rapidly increases and particularly, the reading performance is lowered. The inversion layer is formed by controlling the potential of the third gate electrode and generating a channel onto the semiconductor substrate. Consequently, it is generally difficult to decrease the resistance of the inversion layer. Therefore, it is considered that both the inversion layer and the diffusion layer are used to constitute a data line, and both the inversion layer and the diffusion layer form a reading channel with the result that the resistance value of the reading channel is lowered. However, the problems (2) and (3) become conspicuous by forming the diffusion layer.

Furthermore, Patent Document 3 which was found in the investigation of the applicant does not describe a structure in which the word line and the bit line intersect each other nor the problem resulting therefrom.

The above and other objects and novel characteristics of the present invention will be apparent from the description of this specification and the accompanying drawings.

The typical ones of the inventions disclosed in this application will be briefly described as follows.

That is, a semiconductor device of the present invention comprises a first charge retaining region which is formed on a semiconductor substrate of a first conductive type interposing a first insulation layer therebetween, a second charge retaining region which is formed on the semiconductor substrate interposing a second insulation layer therebetween, a first gate electrode which extends in a first direction and which is formed on the first charge retaining region interposing a first gate insulation layer, a second gate electrode which extends in the first direction and which is formed on the second charge retaining region interposing a second gate insulation layer therebetween, and a semiconductor layer which is formed on the semiconductor substrate and extending in a second direction so as to intersect the first and the second gate electrode; wherein a first impurity region of a second conductive type is formed on the semiconductor layer.

As seen from a different viewpoint, a semiconductor device of the present invention comprises a charge accumulating region which is formed on a semiconductor substrate of a first conductive type, a semiconductor layer which is formed on the semiconductor substrate, and a gate electrode which is formed on the charge accumulating region and the semiconductor layer interposing an insulation layer therebetween; wherein the thickness of the insulation layer between the semiconductor layer and the gate electrode is thicker than the thickness of the insulation layer between the charge accumulating region and the gate electrode.

Furthermore, as seen from a viewpoint of a method for producing the semiconductor device, the method of the present invention comprises steps of (a) forming a charge accumulating region, (b) forming a side spacer on a sidewall of the charge accumulating region, (c) forming a semiconductor layer on a semiconductor substrate by using the charge accumulating region and the side spacer as a mask, and (d) forming a conductive region on the semiconductor layer.

The effects obtained by typical aspects of the present invention will be briefly described below.

Higher integration of the semiconductor device can be attained.

### BRIEF DESCRIPTIONS OF THE DRAWINGS

FIG. 1 is a plan view showing a main part of a memory array structure of a non-volatile semiconductor memory device according to one embodiment of the present invention;
FIG. 2 is a sectional view of a main part of a semiconductor substrate taken along line A-A' of FIG. 1;
FIG. 3 is a sectional view of a main part of the semiconductor substrate taken along line B-B' of FIG. 1;
FIG. 4 is a sectional view of a main part of the semiconductor substrate taken along line C-C' of FIG. 1;
FIG. 5 is a sectional view of a main part of the semiconductor substrate taken along line D-D' of FIG. 1;
FIG. 6 is a sectional view of a main part of the semiconductor substrate taken along line E-E' of FIG. 1;
FIG. 7 is a circuit diagram for explaining a reading operation of the non-volatile semiconductor memory device according to one embodiment of the present invention;
FIG. 8 is a circuit diagram for explaining a writing operation of the non-volatile semiconductor memory device according to one embodiment of the present invention;
FIG. 9 is a variation example of a laminated semiconductor layer portion in FIG. 2 or 3;
FIG. 10 is a sectional view of a main part of the semiconductor substrate showing a method for producing the non-volatile semiconductor memory device according to one embodiment of the present invention;
FIG. 11 is a plan view of the main part of the semiconductor substrate showing the method for producing the non-volatile semiconductor memory device according to one embodiment of the present invention;
FIG. 12 is a sectional view of the main part of the semiconductor substrate showing the method for producing the non-volatile semiconductor device according to one embodiment of the present invention;
FIG. 13 is a sectional view of the main part of the semiconductor substrate showing the method for producing the non-volatile semiconductor device according to one embodiment of the present invention;
FIG. 14 is a sectional view of the main part of the semiconductor substrate showing the method for producing the non-volatile semiconductor device according to one embodiment of the present invention;
FIG. 15 is a sectional view of the main part of the semiconductor substrate showing the method for producing the non-volatile semiconductor device according to one embodiment of the present invention;
FIG. 16 is a sectional view of the main part of the semiconductor substrate showing the method for producing the non-volatile semiconductor device according to one embodiment of the present invention;
FIG. 17 is a sectional view of the main part of the semiconductor substrate showing the method for producing the non-volatile semiconductor device according to one embodiment of the present invention;
FIG. 18 is a sectional view of the main part of the semiconductor substrate showing the method for producing the non-volatile semiconductor device according to one embodiment of the present invention;
FIG. 19 is a sectional view of the main part of the semiconductor substrate showing the method for producing the non-volatile semiconductor device according to one embodiment of the present invention;
FIG. 20 is a sectional view of the main part of the semiconductor substrate showing the method for producing the non-volatile semiconductor device according to one embodiment of the present invention;
FIG. 21 is a sectional view of the main part of the semiconductor substrate showing the method for producing the non-volatile semiconductor device according to one embodiment of the present invention;
FIG. 22 is a plan view of the main part of the semiconductor substrate showing the method for producing the non-volatile semiconductor device according to one embodiment of the present invention;
FIG. 23 is a sectional view of the main part of the semiconductor substrate showing the method for producing the non-volatile semiconductor device according to one embodiment of the present invention;
FIG. 24 is a sectional view of the main part of the semiconductor substrate showing the method for producing the non-volatile semiconductor device according to one embodiment of the present invention;
FIG. 25 is a sectional view of the main part of the semiconductor substrate showing the method for producing the non-volatile semiconductor device according to one embodiment of the present invention;
FIG. 26 is a sectional view of the main part of the semiconductor substrate showing the method for producing the non-volatile semiconductor device according to one embodiment of the present invention;
FIG. 27 is a sectional view of the main part of the semiconductor substrate showing the method for producing the non-volatile semiconductor device according to one embodiment of the present invention;
FIG. 28 is a plan view of a main part showing a memory array structure of a non-volatile semiconductor memory device according to another embodiment of the present invention;
FIG. 29 is a sectional view of a main part of a semiconductor substrate taken along line A-A' of FIG. 28;
FIG. 30 is a sectional view of a main part of the semiconductor substrate taken along line B-B' of FIG. 28;
FIG. 31 is a sectional view of a main part of the semiconductor substrate taken along line C-C' of FIG. 28;
FIG. 32 is a circuit diagram of the non-volatile semiconductor memory device according to another embodiment of the present invention;
FIG. 33 is a sectional view of a main part of the semiconductor substrate showing a method for producing the non-volatile semiconductor memory device according to another embodiment of the present invention;
FIG. 34 is a sectional view of the main part of the semiconductor substrate showing the method for producing the non-volatile semiconductor memory device according to another embodiment of the present invention;
FIG. 35 is a plan view of a main part showing a memory array structure of a non-volatile semiconductor memory device according to another embodiment of the present invention;
FIG. 36 is a sectional view of a main part of the semiconductor substrate taken along line A-A' of FIG. 35;
FIG. 37 is a sectional view of a main part of the semiconductor substrate taken along line B-B' of FIG. 35;
FIG. 38 is a sectional view of a main part of the semiconductor substrate taken along line C-C' of FIG. 35;
FIG. 39 is a sectional view of a main part of the semiconductor substrate showing a method for producing the non-volatile semiconductor memory device according to another embodiment of the present invention;
FIG. 40 is a sectional view of a main part of the semiconductor substrate showing a method for producing the non-volatile semiconductor memory device according to another embodiment of the present invention;
FIG. 41 is a sectional view of the main part of the semiconductor substrate showing the method for producing the non-volatile semiconductor memory device according to another embodiment of the present invention;
FIG. 42 is a sectional view of the main part of the semiconductor substrate showing the method for producing the non-volatile semiconductor memory device according to another embodiment of the present invention;
FIG. 43 is a sectional view of the main part of the semiconductor substrate showing the method for producing the non-volatile semiconductor memory device according to another embodiment of the present invention;
FIG. 44 is a plan view of a main part showing a memory array structure of a non-volatile semiconductor memory device according to another embodiment of the present invention;
FIG. 45 is a sectional view of a main part of a semiconductor substrate taken along line A-A' of FIG. 44;
FIG. 46 is a sectional view of a main part of the semiconductor substrate taken along line B-B' of FIG. 44;
FIG. 47 is a sectional view of a main part of the semiconductor substrate taken along line C-C' of FIG. 44;
FIG. 48 is a sectional view of a main part of the semiconductor substrate showing a method for producing the non-volatile semiconductor memory device according to another embodiment of the present invention;
FIG. 49 is a sectional view of the main part of the semiconductor substrate showing the method for producing the non-volatile semiconductor memory device according to another embodiment of the present invention;
FIG. 50 is a sectional view of the main part of the semiconductor substrate showing the method for producing the non-volatile semiconductor memory device according to another embodiment of the present invention;
FIG. 51 is a modified example of the semiconductor substrate taken along line A-A' of FIG. 44; and
FIG. 52 is a sectional view of a main part of the semiconductor substrate taken along line A-A' of FIG. 35, the view showing a memory array structure of the non-volatile semiconductor memory device according to another embodiment of the present invention.

### DESCRIPTIONS OF THE PREFERRED EMBODIMENTS

Hereinafter, embodiments of the present invention will be described in detail with reference to the accompanying drawings. Note that components having the same function are denoted by the same reference symbols throughout the drawings for describing the embodiment, and the repetitive description thereof will be omitted.

### (First Embodiment)

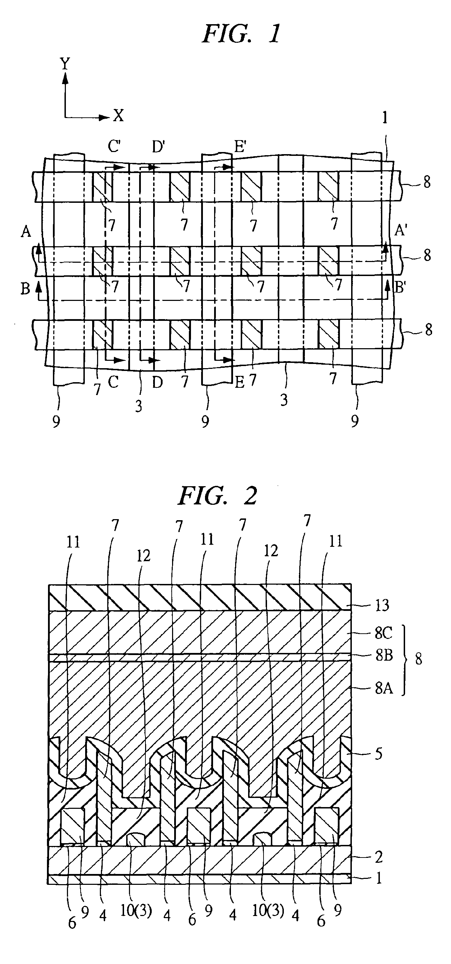

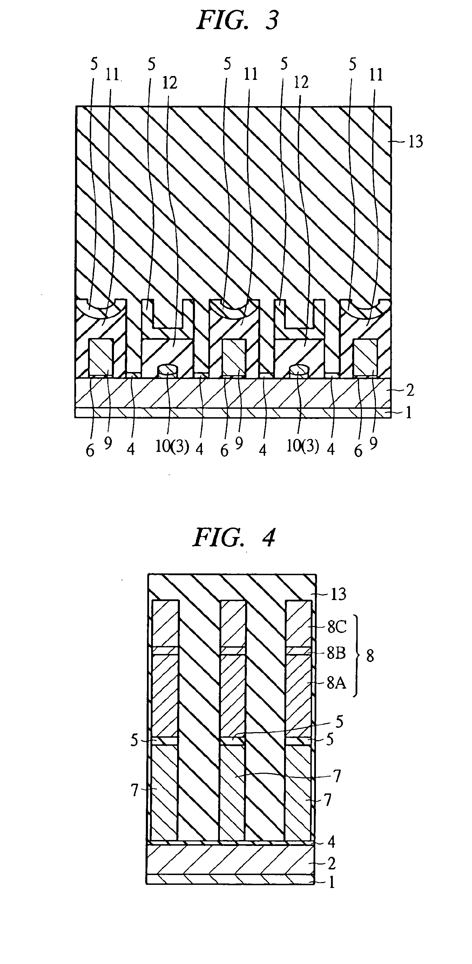

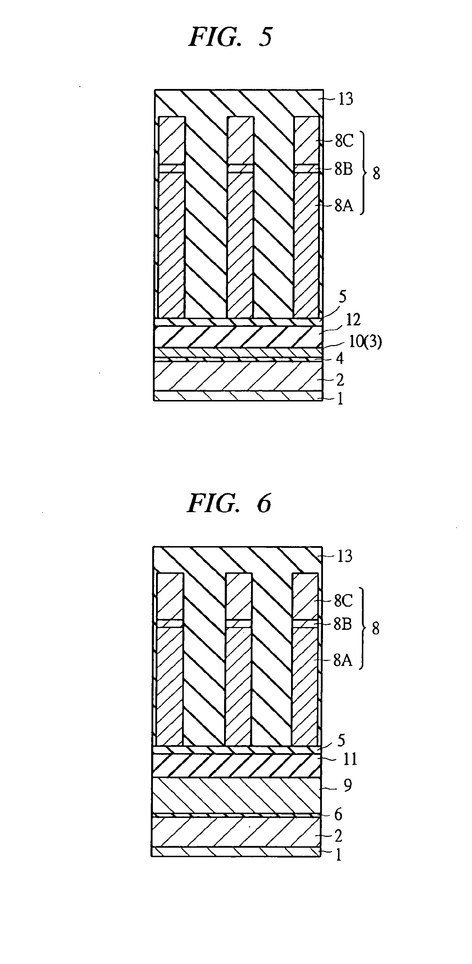

FIG. 1 through FIG. 6 show a memory array of a semiconductor memory device according to a first embodiment of the present invention. FIG. 1 is a plan view of a main part showing a memory array structure. FIG. 2 is a sectional view of a main part of a semiconductor substrate taken along line A-A' of FIG. 1. FIG. 3 is a sectional view of a main part of the semiconductor substrate taken along line B-B' of FIG. 1. FIG. 4 is a sectional view of a main part of the semiconductor substrate taken along line C-C' of FIG. 1. FIG. 5 is a sectional view of a main part of the semiconductor substrate taken along line D-D' of FIG. 1. FIG. 6 is a sectional view of a main part of the semiconductor substrate taken along line E-E' of FIG. 1. In FIG. 1 (the plan view), for the sake of facilitating the visualization of FIG. 1, a part of members such as an insulation layer is omitted in the drawing.

The semiconductor memory device according to the first embodiment is a so-called flash memory and the device has a memory array in which a plurality of memory cells are formed on a p-type well 2 of a main surface of the semiconductor substrate (hereinafter referred to as the substrate) composed of single-crystal silicon. Each of the memory cells has a laminated semiconductor layer 10, an n-type conductive region 3, a floating gate (a first gate electrode) 7, a control gate (a second gate electrode) 8 and an assist gate (a third gate electrode) 9.

The floating gate (a charge retaining region) 7 of the memory cell is formed on the p-type well 2 interposing a first insulation layer 4 therebetween and composed of, for example, an n-type polycrystalline silicon film as shown in FIG. 2. A gap between the floating gates 7 of adjacent memory cells is insulated by silicon oxide films 11 and 12 in a row direction (an X-direction) of FIG. 1 and is insulated by an silicon oxide film 13 in a column direction (a Y-direction) of FIG. 1 as shown in FIG. 3 and FIG. 4. Incidentally, it is only shown that boundaries of the silicon oxide films 11, 12 and 13 in FIG. 3 are formed at different steps.

The control gate 8 is formed on the upper portion of the floating gate 7 interposing a second gate insulation layer 5 therebetween as shown in FIG. 2. The control gate 8 is composed of a poly-metal film having an n-type polycrystalline silicon film 8A, a tungsten nitride (WN) film 8B, and a tungsten (W) film 8C laminated in this order. The control gates 8 of the plurality of memory cells which are arranged along the row direction (the X-direction) of FIG. 1 are connected to each other to constitute a word line WL which extends in the row direction. A gap between the adjacent control gates 8 in the Y-direction is insulated with the silicon oxide film 13 as shown in FIG. 4.

The assist gate 9 is formed on the p-type well 2 interposing a third gate insulation layer 6 therebetween as shown in FIG. 2 and the assist gate 9 is composed of, for example, an n-type poly-silicon film. Furthermore, as shown in FIG. 3 and FIG. 6, the assist gates 9 of a plurality of memory cells arranged along the column direction (the Y-direction) are connected to each other and extending in the Y-direction.

As shown in FIG. 2, the laminated semiconductor layer (stacked layer) 10 is formed on the p-type well 2 of the semiconductor substrate, and the n-type conductive region 3 is formed on the stacked layer 10. Furthermore, as shown in FIG. 3 and FIG. 5, the stacked layer 10 and the n-type conductive region 3 of the plurality of memory cells which are arranged along the column direction (the Y-direction) of FIG. 1 are connected to each other and extending in the Y-direction.

Furthermore, the floating gate 7 and the control gate 8 are insulated from each other by the second gate insulation layer 5. The floating gate 7 and the assist gate 9 are insulated from each other by the silicon oxide film 11. The floating gate 7 and the p-type well 2 are insulated from each other by the first gate insulation layer 4.

Furthermore, the assist gate 9 and the control gate 8 are insulated from each other by the second gate insulation layer 5 and the silicon oxide film 11, and the assist gate 9 and the p-type well 2 are insulated from each other by the third gate insulation layer 6.

Furthermore, the n-type conductive region 3 in the laminated semiconductor layer 10 and the control gate 8 are insulated from each other by the silicon oxide layer 12 and the second gate insulation layer 5.

The source and the drain of the memory cell comprises a inversion layer formed on the p-type well 2 on a lower portion of the assist gate 9 and the n-type conductive region 3 at the time of applying a positive voltage to the assist gate 9 which extends in the Y-direction of FIG. 1.

In this manner, in the flash memory according to the first embodiment, the source and drain of the memory cell transistor is used as the local data line, namely, the data line is formed under the word line with the result that a so-called contact-less type memory cell array structure is adopted wherein a contact hole for the data line is not provided for each of the memory cells.

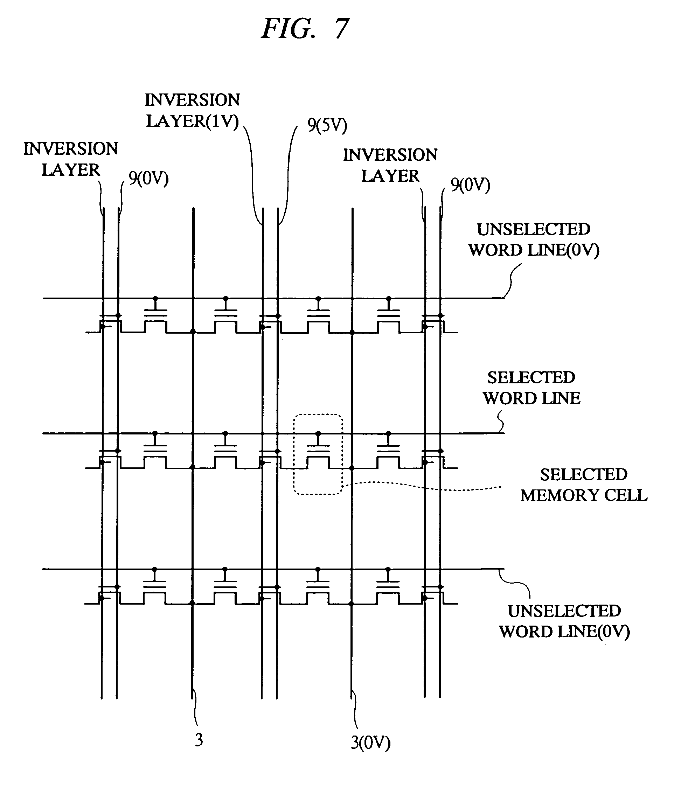

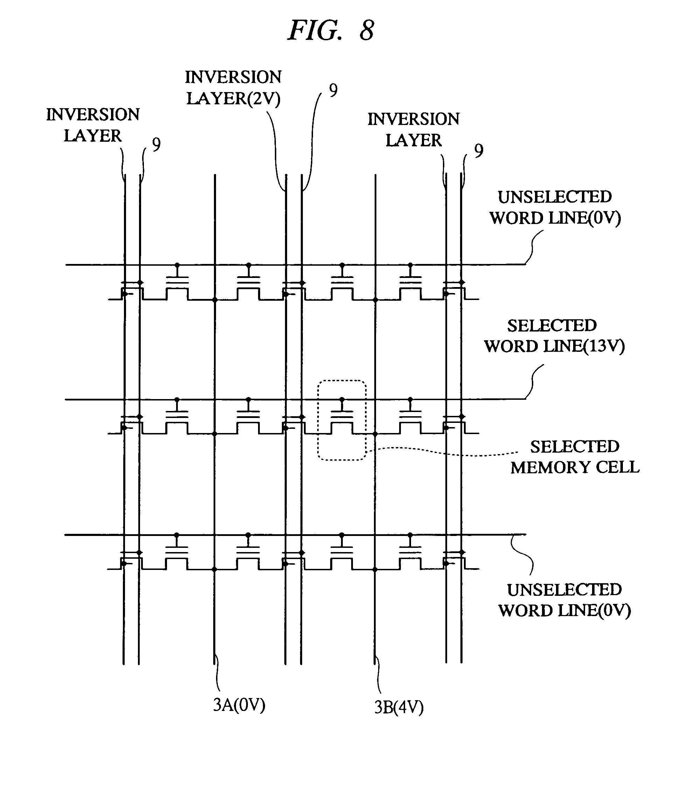

An operation of the memory cell will be explained by using FIG. 7 and FIG. 8. At the time of reading, as shown in FIG. 7, a voltage of about 5V is applied to the assist gate 9 adjacent to a selected memory cell whereas an inversion layer is formed on a lower portion thereof and this inversion layer is used as the drain. Incidentally, a voltage of about 1V is supplied to this drain. On the other hand, the n-type conductive region 3 adjacent to the selected memory cell is used as the source, and a reading channel is formed with the inversion layer and the n-type conductive region 3. To an unselected word line, a voltage of 0V is applied or, in some cases, a negative voltage of about -2V is applied thereto to turn off an unselected memory cell while applying a voltage to the control gate 8 (word line WL) of the selected memory cell to judge the threshold value of the memory cell.

On the other hand, at the time of writing, as shown in FIG. 8, two n-type conductive regions 3 sandwiching the selected memory cell are used as the source and drain. A voltage of about 4V is applied to an n-type conductive region 3B of the drain, a voltage of about 2V is applied to the assist gate 9 in the vicinity of the selected memory cell, and a voltage of about 13V is applied to the control gate 8 (word line WL) of the selected memory cell respectively to hold an n-type conductive region 3A and the p-type well 2 of the source to 0V. Consequently, a channel is formed on the p-type well 2 of the lower portion of the assist gate 9 with the result that the hot electron which is generated in the channel at an end portion of the floating gate 7 on the source side is injected into the floating gate 7.

According to the first embodiment, it is possible to increase a cross-section area of the n-type conductive region 3 than that in the case where the region 3 is formed in the conventional p-type well by stacking the laminated semiconductor layer 10. Accordingly, since the resistance of the data line can be decreased, the resistance value of the whole reading channel can be lowered. Furthermore, the impurity concentration of the n-type conductive region 3 can be lowered as compared with the conventional case because the cross-section area is increased by stacking of the semiconductor layer with the result that a junction voltage of the p-type well 2 can be improved. Furthermore, in the n-type conductive region 3 which becomes the source or drain, the channel length is made longer with respect to the case in which the n-type diffusion layer is formed in the conventional p-type well with the result that the memory cell transistor has high short-channel effect endurance. This can be established in a similar manner both at the time of reading and at the time of writing.

It is expected that the data line resistance can be further decreased by stacking of the semiconductor layer 10 to a height contacting the second gate insulation layer 5 to increase the cross-section area of the n-type conductive region 3. On the other hand, since the second gate insulation layer 5 which runs across the upper portion of the semiconductor layer 10 strengthens a capacitive coupling of the floating gate 7 and the control gate 8, it is desired that the film thickness is thin and the dielectric constant is high. At this time, there arises a problem in that capacitive coupling occurs between the control gate 8 and the n-type conductive region 3 in the same manner with the result that static electricity interference is generated therein. Furthermore, there are problems in the case where, when a high voltage is biased between the control gate 8 and the n-type conductive region 3, the leakage current through the second gate insulation layer 5 therebetween and the insulation breakdown occur. Consequently, according to the first embodiment, there is provided a structure in which the second gate insulation layer 5 and the silicon oxide film 12 which has the dielectric rate same as or less than the second gate insulation layer 5 are provided therein between the control gate 8 and the n-type conductive region 3. Consequently, it becomes possible to solve such problems as the prevention of the interference from the control gate 8, the leakage current and the insulation breakdown.

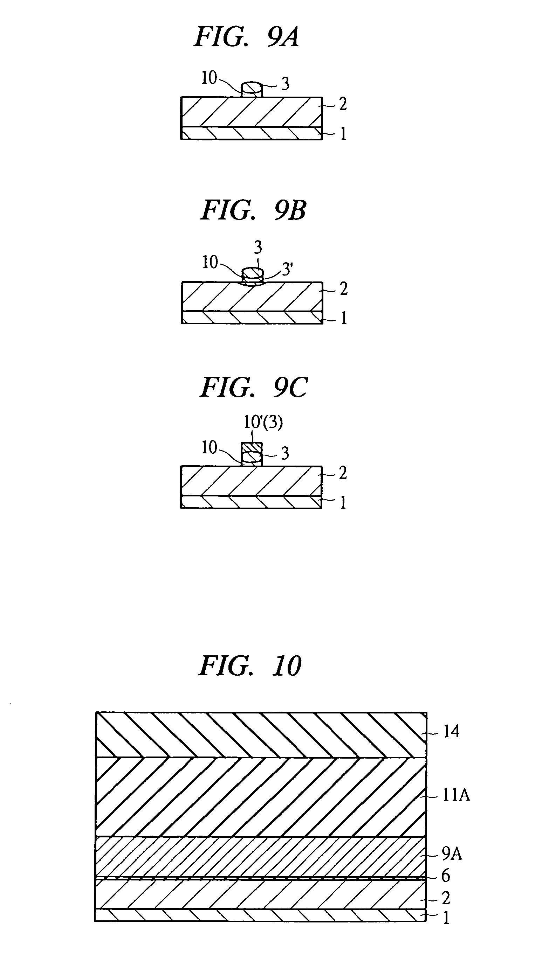

Furthermore, as shown in FIG. 2, the whole semiconductor layer 10 is taken as the n-type conductive region. However, as shown in FIG. 9A, by forming the n-type conductive region 3 offsetting an upper portion in the laminated semiconductor layer 10, it is possible to secure an effective channel length and a further improvement in the punch-through endurance.

In addition, in FIG. 9A, the impurity concentration of the semiconductor layer 10 laminated between the n-type conductive region 3 and the p-type well 2 is formed so as to be lower than that of the p-type well 2 with the result that further improvement of junction voltage is enabled.

A structure shown in FIG. 9B is an example in which the n-type conductive region 3 is divided into two layers having different impurity concentrations of n⁺ and n⁻ (3') and an n⁻ conductive region 3' is formed in such a manner that the n⁻ conductive region 3' comes into contact with the p-type well 2. At this time, the n⁻ conductive region 3' may be formed not only in the stacked layer 10 but also across the stacked layer 10 to the inside of the p-type well 2. In this case, a countermeasure against junction voltage and punch-through is enabled at the n-region and the impurity concentration of the n⁺ region can be further heightened. Consequently, the structure is effective in the case where the cross-section area is not sufficient even in the case of laminating the stacked layer 10.

FIG. 9C is a view showing a structure in which the stacked layer 10 is formed by laminating a single-crystal silicon film and a polycrystalline silicon film 10'. It is possible to realize a further decrease in the data line resistance by using a polycrystalline silicon film 10' in which concentration of the impurity to be activated can be heightened than that of the single-crystal silicon film.

Furthermore, according to the first embodiment, as shown in FIG. 2, there is provided a structure in which the control gate 8 and the n-type conductive region 3 or the assist gate 9 are provided between the floating gates 7 adjacent in the X-direction. As a consequence, each of the floating gates 7 has a capacitive coupling with the control gate 8, the n-type conductive region 3, and the assist gate 9, and so the gate capacitance is increased. Furthermore, capacitive coupling between the adjacent floating gates 7 are shielded by the control gate 8 and the n-type conductive region 3 or the assist gate 9. With these effects, it becomes possible to decrease a static electric interference between the adjacent floating gates 7.

Next, one example of a method for producing a flash memory which is constituted as described above will be explained in an order of steps by using FIGs. 10 through 27.

First, impurity ions are implanted to a substrate 1 composed of p-type single-crystal silicon to form a p-type well 2 with the result that a third gate insulation layer 6 is formed on the well 2, for example, by means of a thermal oxidation method. Subsequently, an n-type polycrystalline silicon film 9A, a silicon oxide film 11A, and a silicon nitride film 14 are successively deposited (FIG. 10). For the deposition of the polycrystalline silicon film 9A, the silicon oxide film 11A and the silicon nitride film 14, for example, the CVD (Chemical Vapor Deposition) method can be used.

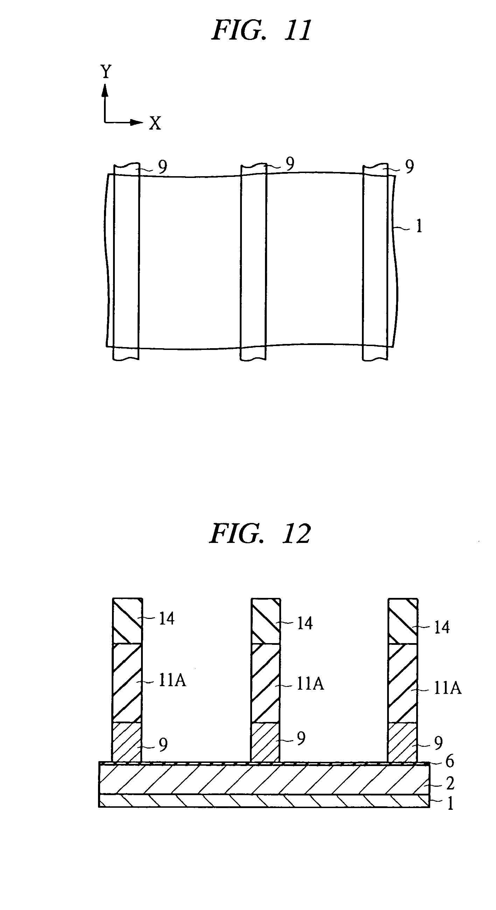

Next, as shown in FIG. 11 and FIG. 12, the oxide nitride film 14, the silicon oxide film 11A and the polycrystalline silicon film 9A are patterned with the lithography and the dry etching technology. By means of the patterning, the silicon nitride film 14, the silicon oxide film 11A and the polycrystalline silicon film 9A constitutes a plurality of stripe-like pillar pattern which extends in a Y-direction to be formed with the result that an assist gate 9 comprising the polycrystalline silicon film 9A is formed.

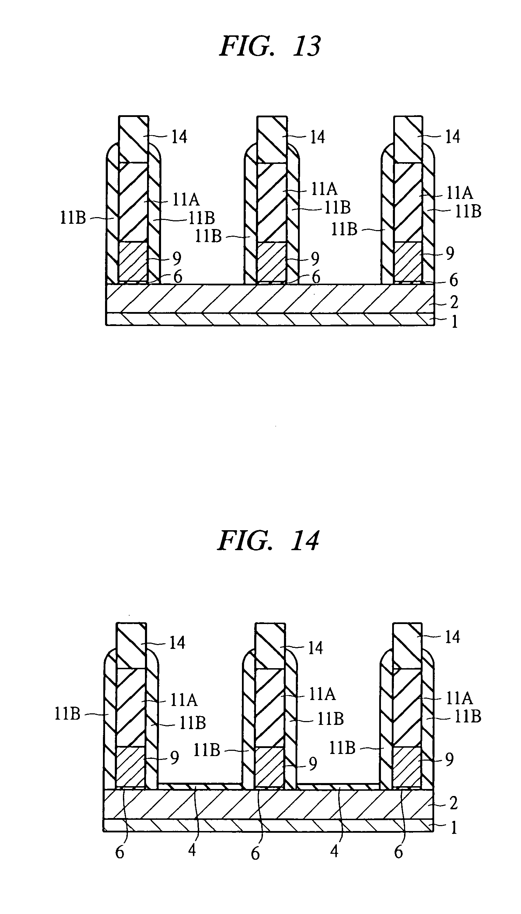

Next, for example, by means of the CVD method, a silicon oxide film is deposited and then conduct anisotropic etching to form a sidewall 11B formed of a silicon oxide film (FIG. 13). Thereafter, for example, by means of the thermal oxidation method, a first gate insulation layer 4 is formed to a thickness of about 10nm on the surface-exposed p-type well 2 (FIG. 14).

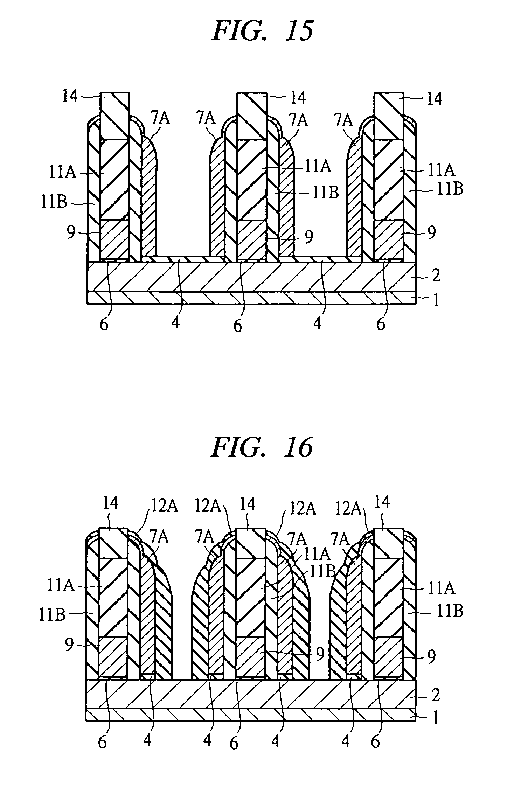

Next, for example, by means of the CVD method, an n-type polycrystalline silicon film is deposited and then conduct an anisotropic etching to form a sidewall 7A composed of the n-type polycrystalline silicon film (FIG. 15). Subsequently, by using the CVD method, a silicon oxide film is deposited and then conduct an anisotropic etching to form a sidewall 12A composed of the silicon oxide film. At this time, the sidewall 7A composed of the n-type polycrystalline silicon film is covered with the sidewall 12A composed of the silicon oxide film so that the surface of the sidewall 11B is not exposed (FIG. 16)

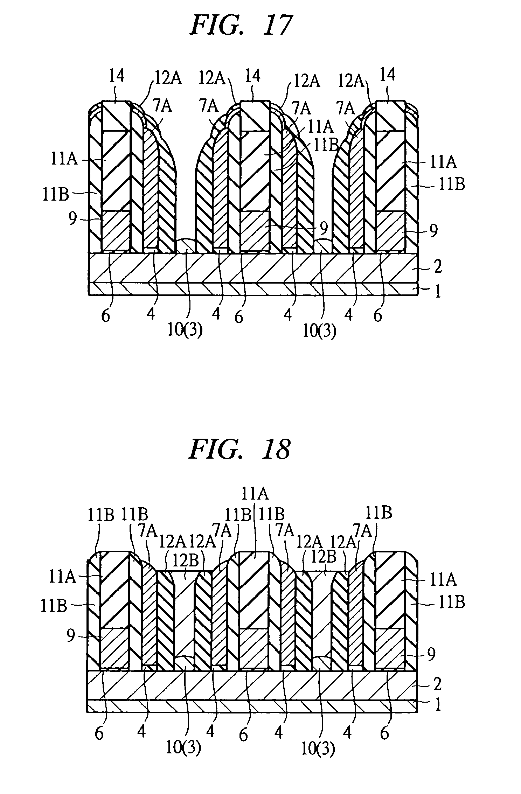

Next, as shown in FIG. 17, for example, a selective epitaxial growth method is used so that a laminated semiconductor layer 10 composed of single-crystal silicon is selectively formed on the exposed p-type well 2. After the epitaxial growth, the stacked semiconductor layer 10 is formed as an n-type conductive region 3 by means of ion implantation of arsenic (As) and phosphorus (P) or thermal diffusion of impurity. At this time, a structure of FIG. 9A can be realized by controlling the formation position of the n-type conductive region 3 by adjusting the condition of the ion implantation and the thermal diffusion of the impurity. Furthermore, a structure of FIG. 9B can be realized by means of, for example, in the ion implantation, dividing implantation for a plurality of ions or implanting a plurality of times changing implantation energy.

Otherwise, it is possible to form the n-type conductive region 3 by mixing impurity gas in the midst of the epitaxial growth. In this case, it becomes possible to control the space distribution of the impurity with good precision. Therefore, it is possible to form the n-type conductive region 3 in a two-layer structure of n⁻/n⁺, and form the region having a mild shift in concentration from the deep portion side to the surface side. Consequently, improvement of junction voltage can be realized.

Otherwise, in a different method, the n-type conductive region 3 may be formed by embedding and etching back the n-type polycrystalline silicon film. In this method, the selectivity in the selective epitaxial growth method pales in problem.

Furthermore, as seen in the case of FIG. 9C, the stacked semiconductor layer 10 may be formed to comprise two layers by embedding and etching back the polycrystalline silicon film 10' after the growth of the single-crystal silicon film through the selective epitaxial growth method.

The n-type conductive region 3 which is formed as described above forms a pattern comprised of a plurality of stripes which extend in the Y-direction with the result that the region 3 functions as a local data line which becomes a source or a drain of the memory cell.

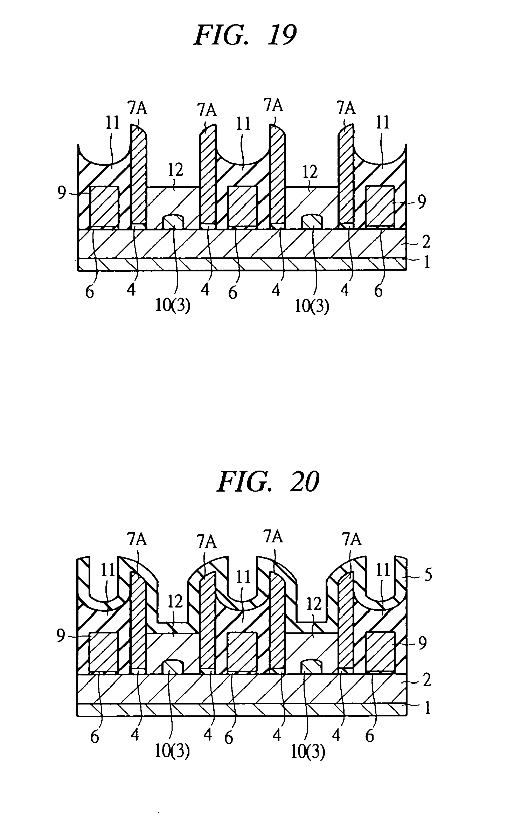

Next, after the silicon oxide film 12B is deposited by the CVD method, the film 12B is planarized by using, for example, the chemical mechanical polishing method to expose the surface of the silicon nitride film 14. Thereafter, the sidewalls 11B and 12A composed of the silicon nitride film 14 and the silicon oxide film, and the silicon nitride film 12B are subjected to the anisotropic etching. At this time, the silicon nitride film 14 is removed by adjusting the etching condition and a part of an upper portion of the sidewall 7A formed of the n-type polycrystalline silicon film is etched (FIG. 18). Furthermore, thereafter, the silicon oxide film 11A and the sidewall 11B formed of the silicon oxide film 11A are combined to form a silicon oxide film 11. Furthermore, the sidewall 12A formed of the silicon oxide film and the silicon oxide film 12B are combined to form a silicon oxide film 12. Subsequently, the silicon oxide films 11 and 12 are subjected to the anisotropic etching. At this time, the thickness of the silicon oxide film 11 on the polycrystalline silicon film 9, and the silicon oxide film 12 on the n-type conductive region 3 are set in such a manner that about 30nm or more is remained (FIG. 19).

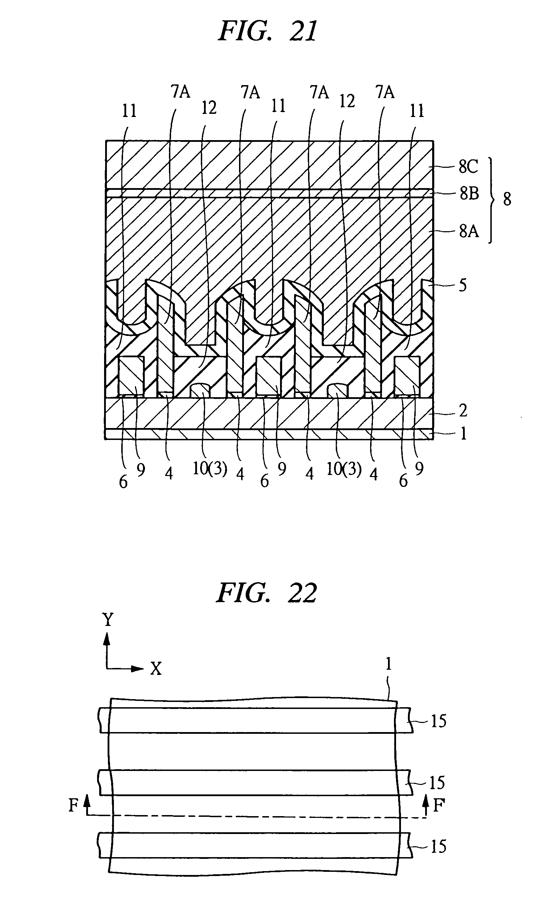

Next, by using, for example, the CVD method, the second gate insulation layer 5 is formed (FIG. 20). This insulation layer is formed of a laminated layer structure of silicon oxide films or silicon oxide film/silicon nitride film/silicon oxide film. After this, a lamination layer of an n-type polycrystalline silicon film 8A/a tungsten nitride film 8B/a tungsten film 8C, namely, a so-called poly-metal film is deposited. In the deposition of this poly-metal film, for example, a combination of the CVD method and the sputtering method is used in the formation thereof (FIG. 21).

Next, a photoresist pattern 15 which extends in an X-direction as shown in FIG. 22 is used as a mask to conduct an anisotropic etching with respect to the tungsten film 8C, the tungsten nitride film 8B, and the n-type polycrystalline silicon film 8A.

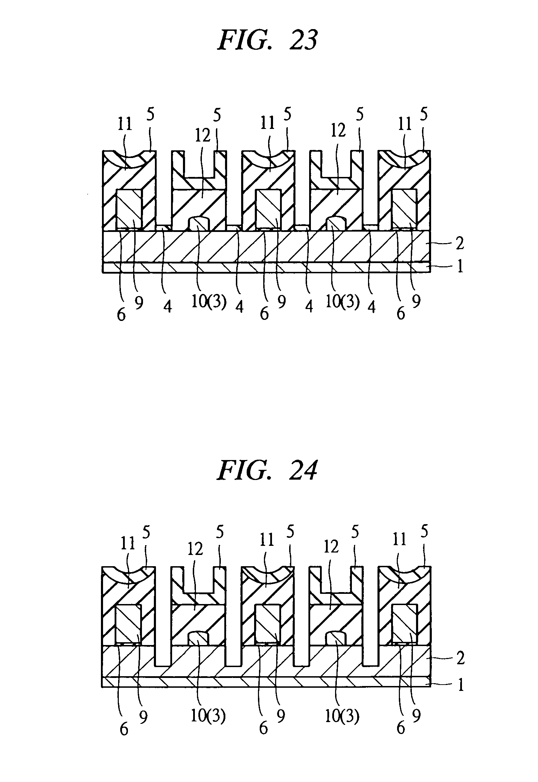

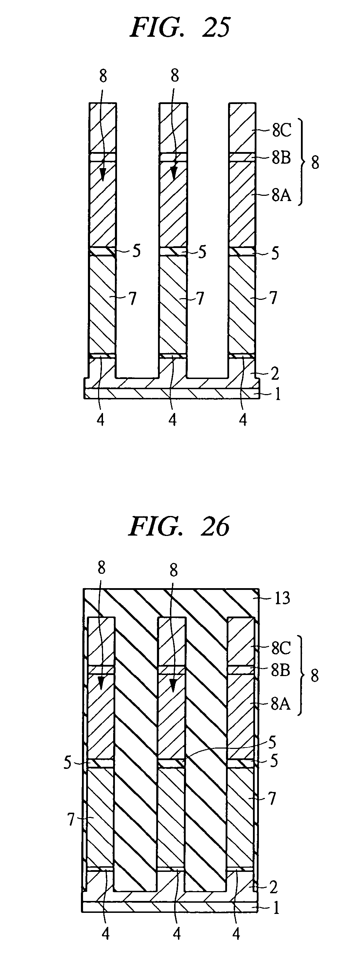

Subsequently, the anisotropic etching is conducted with respect to the second gate insulation layer 5 to expose an upper portion of the sidewall 7A formed of the polycrystalline silicon film. Subsequently, the sidewall 7A formed of polycrystalline silicon film is removed by selectively etching only the polycrystalline silicon film by means of dry etching (FIG. 23), thereby forming the floating gate 7. After this, as shown in FIG. 24, the gate insulation layer 4 and a part of the p-type well 2 may be subjected to anisotropic etching. At this time, the cross-section along the line C-C' in FIG. 1 becomes FIG. 25. It becomes possible to decrease unnecessary leakage current which flows on the surface of the p-type well by forming such recess.

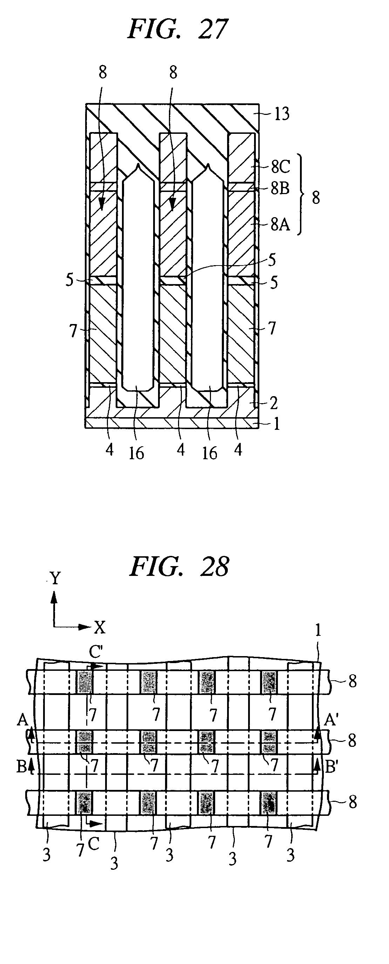

Next, by using, for example, the CVD method, a silicon oxide film 13 is deposited to insulate the floating gate 7 from the periphery thereof. The cross-section C-C' of FIG. 1 at this time corresponds to FIG. 26. At this time, a space 16 may be formed between the floating gates by adjusting the condition. In this case, the cross-section C-C' of FIG. 1 corresponds to FIG. 27. The dielectric constant of the space which is formed in this manner becomes lower than in the case in which the oxide film is embedded. As a consequence, it becomes possible to decrease a static interference between the adjacent floating gates 7.

Thus, as described above, the memory array structure shown in the FIGs. 1 through 6 is completed. Thereafter, although the drawing is omitted, after the interlayer insulation layer is formed, the control gate 8, the p-type well 2, the n-type conductive region 3, a contact hole which leads to the assist gate 9, and a contact hole which supplies electricity to the inversion layer are formed. Subsequently, the metal layer is deposited, and patterned to form wiring with the result that a flash memory is approximately completed.

According to the first embodiment, a substrate only at an area on which the semiconductor layer 10 is formed by using a sidewall 12A is exposed, and the substrate at other areas are covered with the result that the semiconductor layer 10 is selectively formed. With such structure, it is not required to use an expensive mask or the like and it becomes possible to produce the semiconductor layer at a low cost. Furthermore, the sidewall 12A is formed on the sidewall 7A whose upper portion is diagonally formed with the result that the thickness in the height direction becomes thick as compared with the portion which is desired to be exposed. Consequently, it becomes possible to cover the sidewall 7A only by simply subjecting the insulation layer to the anisotropic etching with the result that the simplification of the production steps can be realized.

### (Embodiment 2)

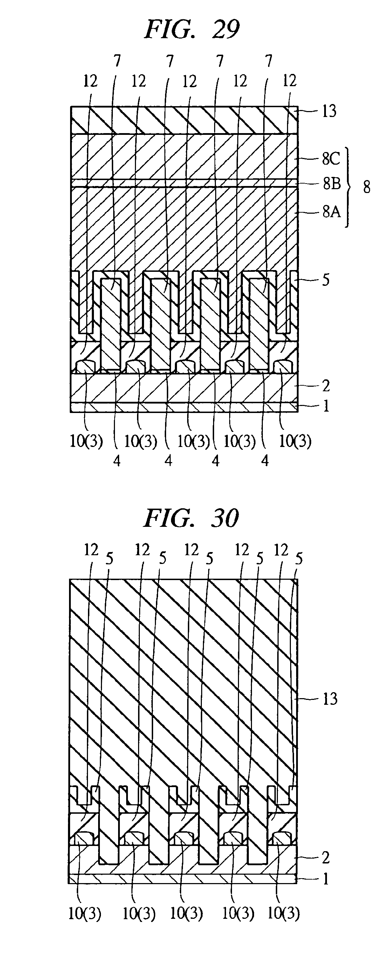

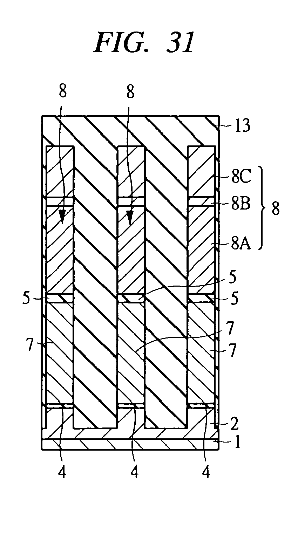

FIGs. 28 through 31 show a memory array of a semiconductor memory device according to a second embodiment of the present invention. FIG. 28 is a plan view of a main part of a memory array structure. FIG. 29 is a sectional view of a semiconductor substrate taken along line A-A' of FIG. 28. FIG. 30 is a sectional view of a main part of the semiconductor substrate taken along line B-B' of FIG. 28. FIG. 31 is a sectional view of a main part of the semiconductor substrate taken along line C-C' of FIG. 28. Incidentally, in FIG. 28 (a plan view), for the sake of facilitating the visualization of the drawings, a part of the members such as an insulation layer is omitted.

In the first embodiment, the assist gate 9 is formed, and the inversion layer which is formed by applying a positive voltage to the assist gate 9 is also used as a local data line. The second embodiment is different from the first embodiment in that, as shown in FIG. 28 through 31, the laminated semiconductor layer 10 and the n-type conductive region 3 are provided instead of the assist gate 9 to be used as a local data a line. With the adoption of this structure, it becomes possible to lower the resistance of the local data line using the laminated semiconductor layer 10 and the n-type conductive region 3. Furthermore, the formation of the assist gate 9 becomes unnecessary and the simplification of the production steps can be realized.

The semiconductor memory device of the second embodiment is a so-called flash memory which has a memory array in which a plurality of memory cells are formed on a p-type well 2 on the main surface of the semiconductor substrate (hereinafter referred to as the substrate) 1 composed of a single-crystal silicon. Each of the memory cells has a floating gate (a first gate electrode) 7 and a control gate (a second gate electrode) 8 as well as two laminated semiconductor layers 10 and the n-type conductive regions 3 which extend in a Y-direction of FIG.28.

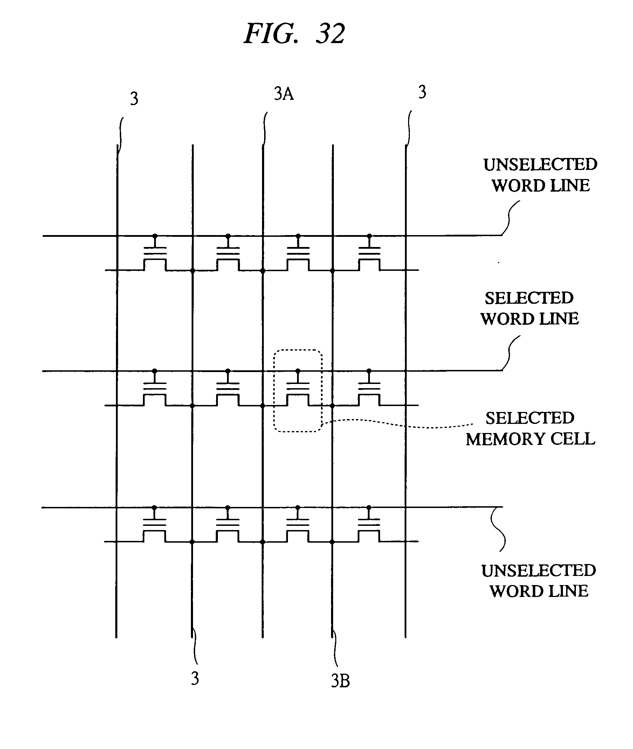

An operation of the memory cell will be explained by using FIG. 32. A reading operation is conducted in the same manner as the first embodiment by using two n-type conductive regions 3 sandwiching a selected memory cell as the source and the drain.

At the time of writing as well, two n-type conductive regions 3 sandwiching the selected memory cell are used as a source and a drain. A voltage of about 4V is applied to an n-type conductive region 3B of the drain, and a voltage of about 13V is applied to the control gate 8 (word line WL) of the selected memory cell respectively with the result that an n-type conductive region 3A of the source and the p-type well 2 are held to 0V. As a consequence, a hot electron which is generated at the drain side of the channel which is formed under the floating gate 7 is injected into the floating gate 7.

Next, one example of a method for producing the flash memory which is constituted as described above will be explained.

In the beginning, in the same manner as the first embodiment, impurity ions are implanted to the substrate 1 composed of a p-type single-crystal silicon to form the p-type well 2.

Next, a first gate insulation layer 4 is formed on the well 2 by means of the thermal oxidation to deposit an n-type polycrystalline silicon film which constitutes the floating gate 7 by means of the CVD method. Subsequently, the polycrystalline silicon film and the first gate insulation layer 4 are patterned with the lithography and the dry etching technology. By means of this patterning, the polycrystalline silicon film and the first gate insulation layer 4 constitute a plurality of stripes-like pattern which extends in the Y-direction to be formed.

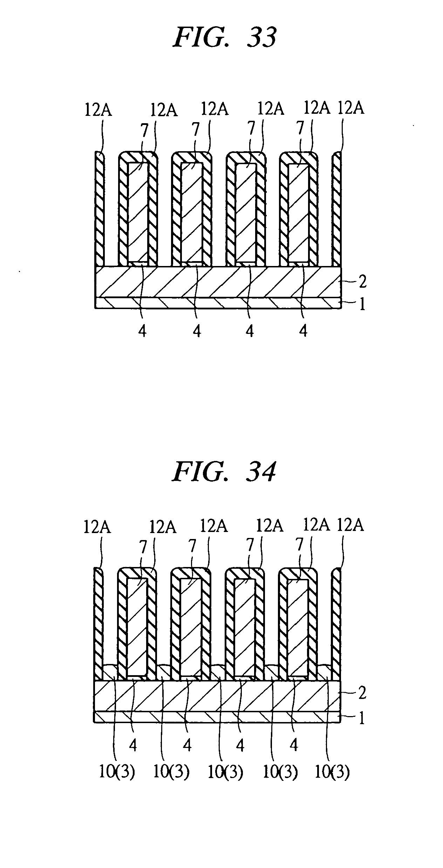

Next, the silicon oxide film is deposited, for example, by means of the CVD method to conduct an anisotropic etching with the result that a sidewall 12A composed of the silicon oxide film is formed (FIG. 33). Here, the sidewall 12A exposes the semiconductor substrate only at a location where the semiconductor layer 10 is desired to be formed in the same manner as the first embodiment while the other portion is formed to be covered.

Next, in the same manner as the first embodiment, the laminated semiconductor layer 10 and the n-type conductive region 3 are formed on the exposed p-type well 2 (FIG. 34). This n-type conductive region 3 constitutes a pattern comprised of a plurality of stripes which extends in the Y-direction and functions as a local data line which forms a source or a drain of the memory cell.

Thereafter, the flash memory shown in FIGs. 28 through 31 are approximately completed by going through the steps same as the steps shown in FIGs. 18 through 27 of the first embodiment.

According to the second embodiment, in the same manner as the first embodiment, it is possible to decrease in line resistance of the local data line comprising the stacked layer 10 and the n-type conductive region 3 and secure a junction voltage. Furthermore, it is possible to effectively suppress a short-channel effect of the memory cell.

Furthermore, as shown in FIG. 9, the impurity region 3 which is formed on the wiring layer 10 may be formed. In this case, it becomes possible to obtain an effect explained in the first embodiment.

### (Embodiment 3)

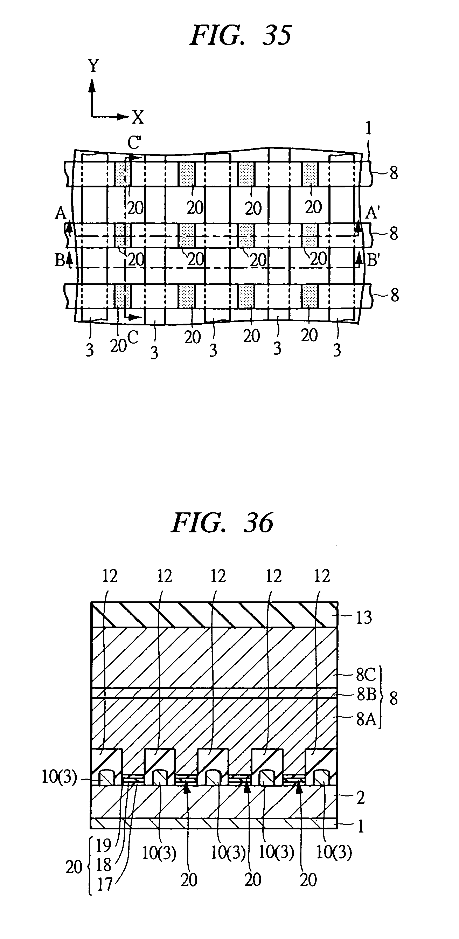

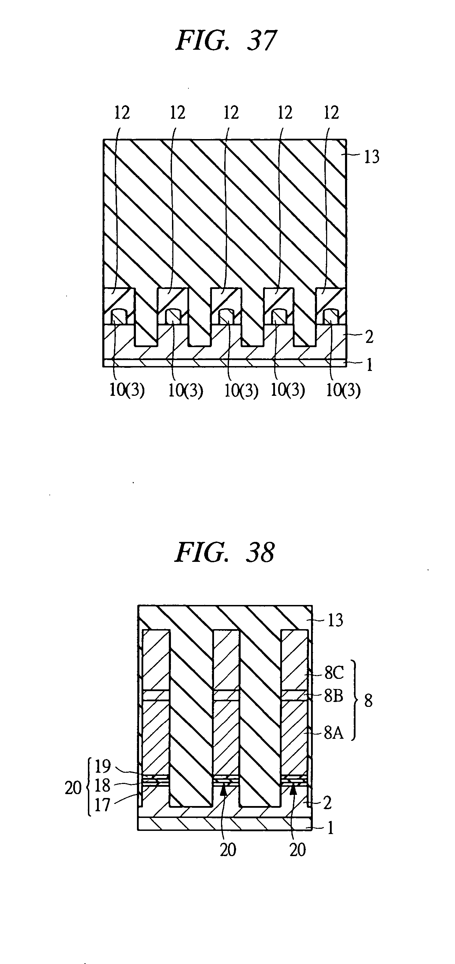

FIGs. 35 through 38 show a memory array of a semiconductor memory device according to a third embodiment of the present invention. FIG. 35 is a plan view of a main part of a memory array structure. FIG. 36 is a sectional view of a main part of a semiconductor substrate taken along line A-A' of FIG. 35. FIG. 37 is a sectional view of a main part of the semiconductor substrate taken along line B-B' of FIG. 35. FIG. 38 is a sectional view of a main part of the semiconductor substrate taken along line C-C' of FIG. 35.

In the first and second embodiments, the floating gate is used as the charge accumulation layer of the memory cell transistor. However, in the third embodiment, as shown in FIGS. 35 through 38, the structure thereof is different in that the structure of the memory cell transistor is formed as a so-called MONOS type structure. Though not shown in the drawings, MNOS-type/MNS-type can be also adopted similarly.

The semiconductor memory device according to the third embodiment has a memory array in which a plurality of memory cells are formed on a p-type well 2 on the main surface of a semiconductor substrate 1 (hereinafter described as the substrate) composed of single-crystal silicon. Each of the memory cells has a gate insulation layer (an ONO film) 20 comprising three layers of tunnel insulation layer (a bottom insulation layer) 17/charge accumulation layer 18/top insulation layer 19, a control gate (a second gate electrode) 8, and two laminated semiconductor layers 10 and an n-type conductive regions 3 which extend in a Y-direction of FIG. 35. In the case of the MNOS type, the gate insulation layer 20 comprises two layers of the bottom insulation layer 17/charge accumulation layer 18. In the case of the MNS type, the insulation layer comprises one layer of the charge accumulation layer 18.

In the MONOS type memory cell transistor, for example, a silicon nitride film is used as a charge accumulation layer. Two bit data can be stored with respect to one memory cell by accumulating charge locally in the vicinity of the source and the drain of the transistor respectively.

An operation of the memory cell is conducted in the same manner as the second embodiment by using two n-type conductive regions 3 sandwiching a selected memory cell as a source and a drain. At the time of writing, a hot electron is generated in the vicinity of the laminated semiconductor layer 10 and the n-type conductive region 3 that functions as the drain with the result that the hot electron is injected into the charge accumulation layer 18 through the bottom insulation layer 17. In the case where 2 bit data is stored, the source/drain of the two n-type conductive regions 3 are replaced with each other to inject the charge into the opposite side region of the charge accumulation layer 18. At the time of erasing, the hot hole is generated by band to band tunneling to be trapped in the charge accumulation layer 18. Otherwise, the data may be erased by applying a voltage of 0V to the control gate 8 (WL), or a positive high voltage to the substrate 1 or the p-type well 2, or pulling the electron to the substrate side by the tunneling.

Next, one example of a method for producing the structure will be explained.

In the beginning, impurity ions are implanted to the substrate 1 composed of p-type single-crystal silicon to form the p-type well 2.

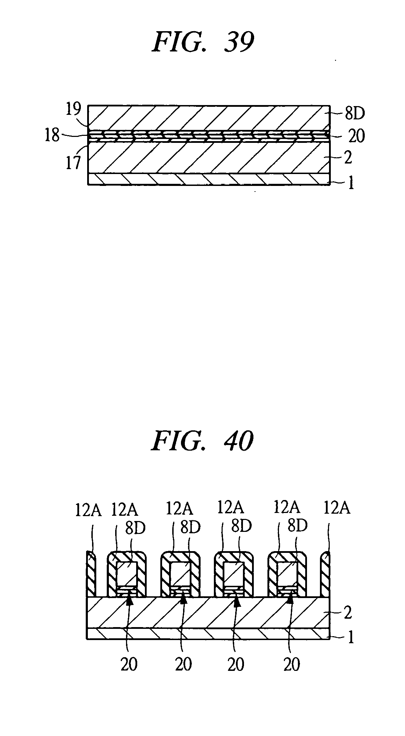

Next, by means of the thermal oxidation method, the tunnel insulation layer 17 to be a bottom insulation layer comprising a silicon oxide film having a thickness of about 7 nm or less is formed on the well 2, then the charge accumulation layer 18 comprising a silicon nitride film having a thickness of about 10 nm or less is deposited by means of the CVD method. Furthermore, the top insulation layer 19 is formed which comprising a silicon oxide film having a thickness of about 5 to 10 nm by means of the CVD method or the thermal oxidation method. Thus, the ONO film 20 is formed which comprises three layers. Thereafter, an n-type polycrystalline silicon film 8D is accumulated, for example, by means of the CVD method (FIG. 39).

Next, the n-type polycrystalline silicon film 8D and the ONO film 20 are patterned by means of the lithography and the dry etching technology. In this patterning, the n-type polycrystalline silicon film 8D and the ONO film 20 constituting a pattern of a plurality of stripes which extends in the Y-direction to be formed.

Next, for example, by means of the CVD method, the silicon oxide film is deposited to conduct an anisotropic etching with the result that a sidewall 12A comprising a silicon oxide film is formed (FIG. 40).

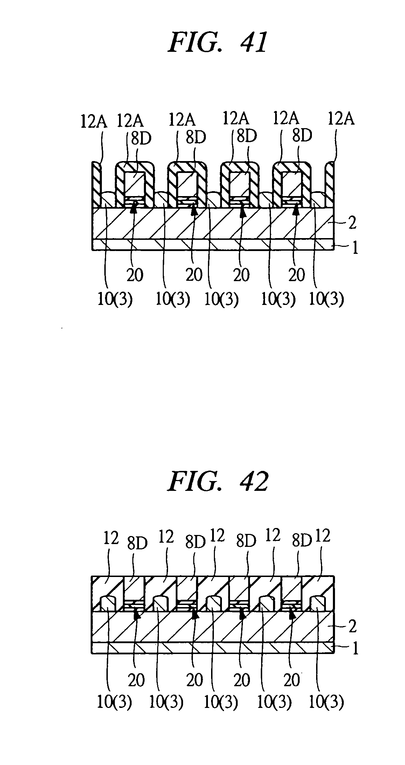

Next, in the same manner as the first embodiment, the laminated semiconductor layer 10 and the n-type conductive region 3 are formed on the exposed p-type well 2 (FIG. 41). This n-type conductive region 3 constitutes a pattern of a plurality of stripes which extends in the Y-direction and functions as a local data line which becomes a source or a drain of the memory cell.

Next, after the silicon oxide film 12B is deposited by means of the CVD method, the film is planarized by means of etch back or a chemical mechanical polishing method to expose the surface of the n-type polycrystalline silicon film 8D. Thereafter, the sidewall 12A comprising the silicon oxide film and the silicon oxide film 12B are together set as a silicon oxide film 12 (FIG. 42).

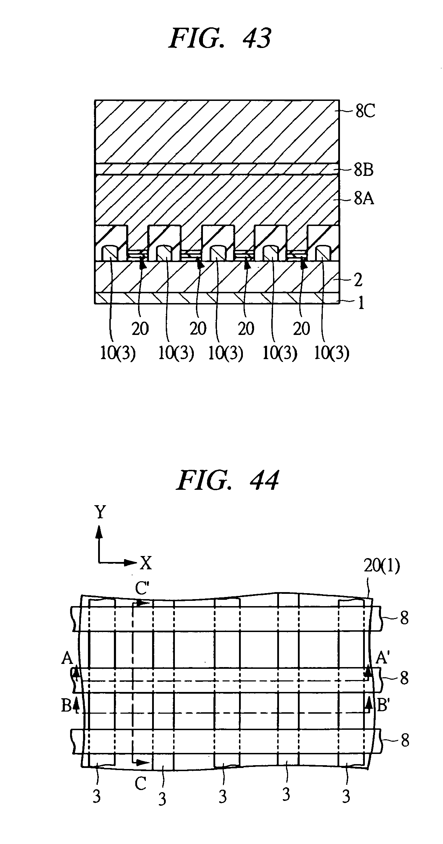

Next, a laminated layer of n-type polycrystalline silicon film 8A/tungsten nitride film 8B/tungsten film 8C, namely a so-called poly-metal film is deposited. In the deposition of this poly-metal film, the deposition is formed by means of a combination of the CVD method and the sputtering method. Thereafter, the n-type polycrystalline silicon films 8A and 8D are together set as an n-type polycrystalline silicon film 8A constituting a poly-metal film (FIG. 43).

Thereafter, an electrically rewritable non-volatile semiconductor memory device shown in FIGs. 35 through 38 is approximately completed by going through the steps same as the steps shown in FIGs. 21 through 27 of the first embodiment.

According to the third embodiment, in the same manner as the first embodiment, it is possible to decrease the resistance of the local data line comprising the accumulated layer 10 and the n-type conductive region 3 and secure the junction voltage, and effectively suppress the short-channel effect of the memory cell.

Furthermore, as shown in FIG. 9, the n-type conductive region (the impurity region) 3 which is formed on the semiconductor layer 10 (wiring layer) may be formed. In such a case, it becomes possible to obtain an effect that is explained in the first embodiment.

### (Embodiment 4)

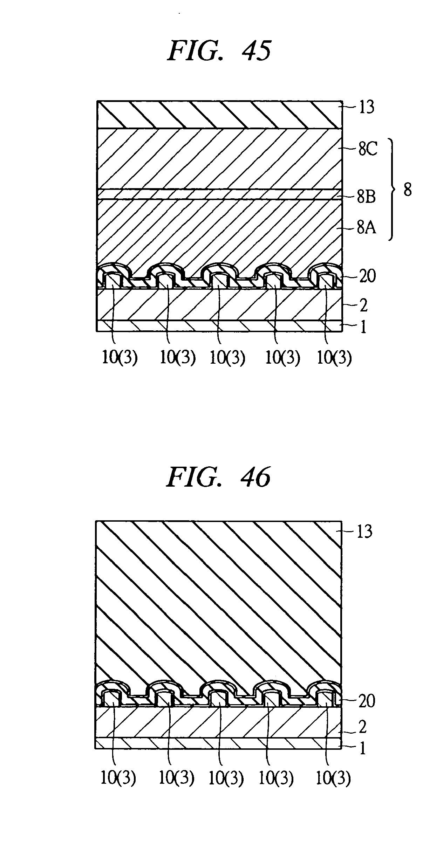

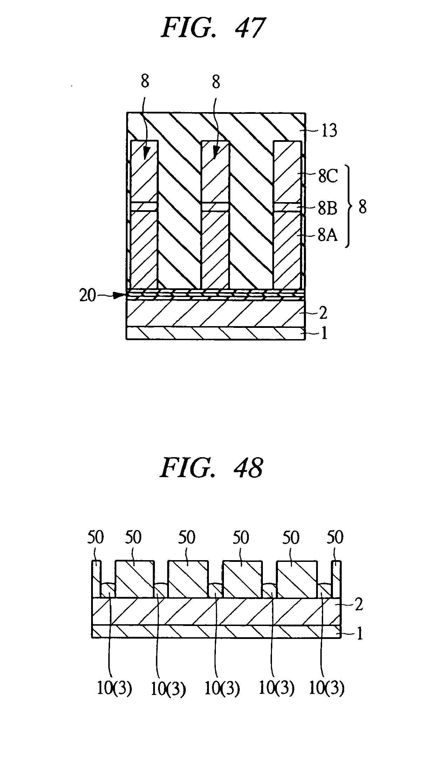

FIGs. 44 through 47 are views showing a memory array of a semiconductor memory device according to a fourth embodiment of the present invention. FIG. 44 is a plan view of a main part of a memory array structure. FIG. 45 is a sectional view of a main part of a semiconductor substrate taken along line A-A' of FIG. 44. FIG. 46 is a sectional view of a main part of the semiconductor substrate taken along line B-B' of FIG. 44. FIG. 47 is a sectional view of a main part of the semiconductor substrate taken along line C-C' of FIG. 44.

In the third embodiment, the stacked layer 10 which constitutes a local data line and the n-type conductive region 3 was formed after the formation of the ONO film 20. Embodiment 4 is different from the third embodiment in that the production steps are reversed. With the adoption of such structure, the simplification of the production steps can be realized.

FIG. 44 through 47 are views showing a case in which a recess of the p-type well 2 and the ONO film 20 are not removed in an open field portion between the control gates 8 (WL) which extend in an X-direction. However, in the same manner as the third embodiment, the recess of the p-type well 2 and the ONO film 20 may be removed. Furthermore, in the fourth embodiment, a special insulation layer is not formed between the semiconductor layer 10 and the control gate 8. This is because, in the non-volatile semiconductor memory device of the type of trapping a charge in the nitride film, no high voltage is required to be applied to the control gate 8 as compared with the semiconductor memory device using a floating gate, and the dielectric constant of the ONO film is not high. Consequently, resulting a small potential change of the control gate 8 with respect to the semiconductor layer 10.

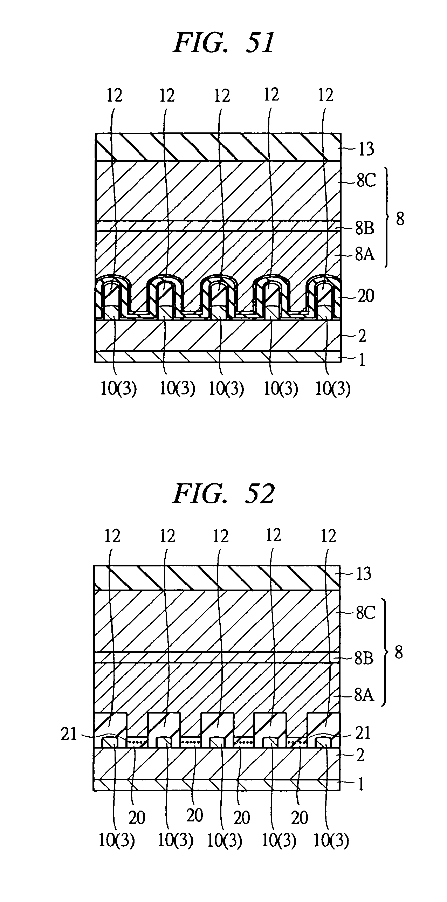

Incidentally, in order to suppress the influence of the potential change of the control gate 8 in the same manner as the first embodiment, as shown in FIG. 51 which is a sectional view of a main part of the semiconductor substrate taken along line A-A' of FIG. 44, a structure may be adopted in which the silicon oxide film 12 may be laminated on the stacked layer 10 and the n-type conductive region 3.

Next, one example of a method for producing the structure will be explained.

In the beginning, the impurity ions are implanted into the substrate 1 composed of p-type single-crystal silicon to form a p-type well 2.

Next, the silicon oxide film is deposited, for example, by means of the CVD method, and the silicon oxide film is patterned into a stripe-like configuration which extends in the Y-direction by means of lithography and dry etching technology. Otherwise, the silicon oxide film may be patterned by using photoresist. In the same manner as the first embodiment, the laminated semiconductor layer 10 and an n-type conductive region 3 may be formed on the exposed p-type well 2 by means of this patterning (FIG. 48). This n-type conductive region 3 constitutes a pattern of a plurality of stripes which extends in the Y-direction and functions as a local data line which constitutes either a source or a drain of the memory cell.

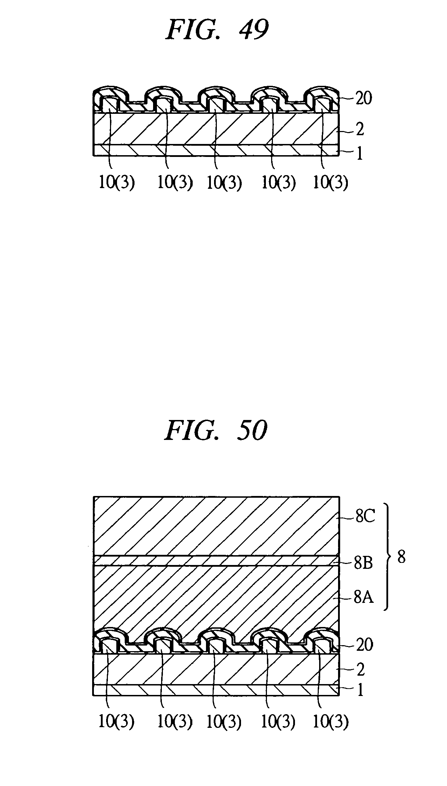

Next, after the silicon oxide film or the photoresist are removed, the ONO film 20 is formed in the same manner as the third embodiment (FIG. 49). Subsequently, a lamination layer of n-type polycrystalline silicon film 8A/tungsten nitride film 8B/tungsten film 8C, namely, a so-called poly-metal film is deposited. The deposition of this poly-metal film is formed by using a combination of, for example, the CVD method and the sputtering method (FIG. 50).

Thereafter, the electrically rewritable non-volatile semiconductor memory device shown in FIGs. 44 through 47 is approximately completed by going through the steps same as the steps shown in FIGs. 21 through 27 of the first embodiment.

According to the fourth embodiment, in the same manner as the first embodiment, it is possible to decrease the resistance of the local data line comprising the stacked layer 10 and the n-type conductive region 3, secure the junction voltage and effectively suppress the short channel effect of the memory cell. Furthermore, the step of processing the ONO film for previously forming the semiconductor layer can be omitted with the result that it becomes possible to simplify the production step.

Furthermore, the n-type conductive region (the impurity region) 3 which is formed on the semiconductor layer (wiring layer) 10 may be formed as shown in FIG. 9. In such a case, it becomes possible to obtain an effect which is explained in the first embodiment.

### (Embodiment 5)

A plan view of a main part of the memory array structure of the semiconductor memory device according to a fifth embodiment of the present invention is, for example provided in FIG. 35. A sectional view of a main part of the semiconductor substrate taken along line A-A' of FIG. 35 at this time is provided in FIG. 52.

According to the third embodiment, a silicon nitride film is used as a charge accumulation layer. However, in the fifth embodiment, as shown in FIG. 52, it is different from the third embodiment in that a plurality of nanodots are used which are embedded in the gate insulation layer as a charge accumulation means and which are insulated from each other on the order of nano meters.

Here, the nanodot refers to a particle-like lump which primarily composed of, for example, single-crystal silicon, or silicon nitride. Furthermore, the nanodots are arranged in plurality in a plane configuration in the gate insulation layer. The gate insulation layer comprises a film which has a higher barrier height than a main component constituting the nanodots, for example, a silicon oxide film. The gate insulation layer has an effect of preventing a movement of a charge accumulated in each of the nanodots. As a consequence, this structure enables an improvement in the charge characteristics.

As one example of a method for producing such a structure, though not shown in the drawings, in the step of forming the gate insulation layer, a tunnel insulation layer is formed by means of the thermal oxidation method in the beginning followed by forming a nanodot 21 composed of single-crystal silicon having a diameter of about 10 nm by means of the low pressure chemical vapor deposition (LPCVD) method. Subsequently, a silicon nitride dot may be formed by means of plasma nitridation. Next, the silicon oxide film which is an insulation layer for separating the nanodots 21 and the control gate 8 is deposited by means of the CVD method.

Thereafter, the electrically rewritable non-volatile semiconductor memory device is approximately completed by passing through the steps same as the steps in the third embodiment.

According to the fifth embodiment, in the same manner as the first embodiment, it is possible to decrease the resistance of the local data line comprising the stacked layer 10 and the n-type conductive region 3, secure the junction voltage and effectively suppress the short channel effect of the memory cell.

Furthermore, as shown in FIG. 9, the n-type conductive region (the impurity region) 3 which is formed on the semiconductor layer (the wiring layer) 10 may be formed. In such a case, it becomes possible to obtain the effect which is explained in the first embodiment.

In the foregoing, the invention made by the inventors of the present invention has been concretely described based on the embodiments. However, it is needless to say that the present invention is not limited to the foregoing embodiments and various modifications and alterations can be made within the scope of the present invention.

## Claims

1. A semiconductor device comprising:
a first charge retaining region which is formed on a semiconductor substrate of a first conductive type interposing a first insulation layer therebetween;
a second charge retaining region which is formed on said semiconductor substrate interposing a second insulation layer therebetween;
a first gate electrode which extends in a first direction and which is formed on said first charge retaining region interposing a first gate insulation layer therebetween;
a second gate electrode which extends in said first direction and which is formed on a second charge retaining region interposing said second insulation layer; and
a semiconductor layer which extends in a second direction and which is formed on said semiconductor substrate in such a manner that the layer intersects said first and second gate electrodes;
wherein a first impurity region of a second conductive type is formed on said semiconductor layer.

2. The semiconductor device according to claim 1,
wherein the whole semiconductor layer is said first impurity region.

3. The semiconductor device according to claim 1,
wherein said semiconductor layer further has a second impurity region of said second conductive type which has a lower impurity concentration than that of said first impurity region, and said second impurity region is provided between said semiconductor substrate and said first impurity region.

4. The semiconductor device according to claim 1,
wherein said semiconductor layer further has a second impurity region of said first conductive type which has a lower impurity concentration than that of said first impurity region, and said second impurity region is provided between said semiconductor substrate and said first impurity region.

5. The semiconductor device according to claim 1,
wherein said semiconductor layer is composed of single-crystal silicon.

6. The semiconductor device according to claim 1,
wherein said semiconductor layer is composed of polycrystalline silicon.

7. The semiconductor device according to claim 1,
wherein said semiconductor layer is formed of a laminated layer of a single-crystal silicon film and a polycrystalline silicon film.

8. The semiconductor device according to claim 1, wherein said first and second gate electrodes are used as word lines, and said semiconductor layer is used as a data line.

9. The semiconductor device according to claim 1,
wherein said first gate insulation layer and a third insulation layer different from said first gate insulation layer are provided between said semiconductor layer and said first gate electrode.

10. The semiconductor device according to claim 1,
wherein a third gate electrode is formed on said semiconductor substrate interposing an insulation layer therebetween in such a manner that said third electrode intersects said first and second gate electrodes, and
an inversion layer which is formed in the semiconductor substrate at the time of applying a voltage to said third gate electrode is used as a data line.

11. The semiconductor device according to claim 1,
wherein said first insulation layer and said second insulation layer are the same layer.

12. A semiconductor device comprising:
a charge accumulating region which is formed on said semiconductor substrate of said first conductive type;
a semiconductor layer which is formed on said semiconductor substrate; and
a gate electrode which is formed on said charge accumulating region and said semiconductor layer interposing said insulation layer therebetween,
wherein the thickness of said insulation layer between said semiconductor layer and said gate electrode is thicker than that of said insulation layer between said charge accumulating region and said gate electrode.

13. The semiconductor device according to claim 12,
wherein said insulation layer between said semiconductor layer and said gate electrode includes said insulation layer between said charge accumulating region and said gate electrode.

14. The semiconductor device according to claim 12,
wherein said gate electrode is formed so as to cover a part of the side of said charge accumulating region.

15. The semiconductor device according to claim 14,
wherein said insulation layer between said gate electrode and said semiconductor layer includes a first insulation layer between said gate electrode and said charge accumulating region and a second insulation layer having a smaller dielectric constant than that of said first insulation layer.

16. The semiconductor device according to claim 12,
wherein said charge accumulating region is a polycrystalline silicon film which is formed on said semiconductor substrate interposing an insulation layer therebetween.

17. The semiconductor device according to claim 12,
wherein said charge accumulating region is a nitride film.

18. The semiconductor device according to claim 17,
where said nitride film is formed on said semiconductor substrate interposing a bottom oxide film therebetween.

19. A method for producing a semiconductor device comprising the steps of:
(a) forming a charge accumulating region;
(b) forming a side spacer on a sidewall of said charge accumulating region;
(c) forming a semiconductor layer on a semiconductor substrate by using said charge accumulating region and said side spacer as a mask; and
(d) forming a conductive region on said semiconductor layer.

20. The method for producing a semiconductor device according to claim 19, further comprising the steps of:
(e) forming a first insulation layer on an upper portion of said semiconductor layer which is formed on said semiconductor substrate;
(f) forming a second gate insulation layer on said charge accumulating region and an upper portion of said first insulation layer; and
(g) forming a second gate electrode constituting a word line on an upper portion of said second insulation layer.

21. The method for producing a semiconductor device according to claim 19,
wherein said charge accumulating region is a conductive type film which is formed on said insulation layer formed on said semiconductor substrate.

22. The method for producing a semiconductor device according to claim 19,
wherein an upper portion of said charge accumulating region is diagonally formed.

23. The method for producing a semiconductor device according to claim 19, further comprising the steps of:
(h) forming a columnar first pattern on said semiconductor substrate;
(i) forming an insulation layer so that it covers said first pattern, and forming a side spacer by providing an anisotropic etching to said insulation layer;
wherein said charge accumulating region forms a conductive type film on said side spacer formed at the step (i) and it is formed by providing an anisotropic etching thereto.
